# EUROPEAN PATENT APPLICATION

(11) **EP 4 654 789 A1**
(43) Date of publication of application: **26.11.2025**
(21) Application number: 25172543.8
(22) Date of filing: 25.04.2025
(51) Int. Cl.: H10H 29/24, H10H 29/80, H10H 29/853, H10H 29/85

(54) **SEMICONDUCTOR CHIP**

(30) Priority: 21.05.2024 CN 202410632575
(71) Applicant: Innolux Corporation, Jhunan Science Park 35053 (TW)
(72) Inventor: KUO, Shu-Ming, 35053 Jhunan Town, Miaoli County (TW); SHIH, Jian-Jung, 35053 Jhunan Town, Miaoli County (TW); HSIEH, Tsau-Hua, 35053 Jhunan Town, Miaoli County (TW)
(74) Representative: Becker, Eberhard

(57) **Abstract**

The disclosure provides a semiconductor chip (100) including a first semiconductor element (110), a second semiconductor element (120), a filling layer (130), a transparent conductive layer (140) and a first metal layer (150). The second semiconductor element (120) is adjacent to the first semiconductor element (110). The filling layer (130) wraps the first semiconductor element (110) and the second semiconductor element (120). The transparent conductive layer (140) is disposed on the filling layer (130). The transparent conductive layer (140) electrically connects the first semiconductor element (110) and the second semiconductor element (120). The first metal layer (150) is disposed under the filling layer (130) and includes a first portion (151) and a second portion (152). The first portion (151) is electrically connected to at least one of the first semiconductor element (110) and the second semiconductor element (120). The second portion (152) is disposed on a side surface (133) of the filling layer (130). The semiconductor chip (100) of the disclosure is adapted to reduce a defect rate or power consumption.

## Description

### BACKGROUND

### Technical Field

The disclosure relates to a semiconductor chip, and particularly relates to a semiconductor chip adapted to reduce a defect rate or power consumption.

### Description of Related Art

Electronic devices or spliced electronic devices have been widely used in different fields such as communication, display, automobile, or aviation, etc. Along with rapid development of electronic devices, the electronic devices are developed towards a trend of being lighter and thinner, so that reliability or quality requirements of the electronic devices become higher.

### SUMMARY

The disclosure is directed to a semiconductor chip, which is adapted to reduce a defect rate or power consumption.

An embodiment of the disclosure provides a semiconductor chip including a first semiconductor element, a second semiconductor element, a filling layer, a transparent conductive layer and a first metal layer. The second semiconductor element is adjacent to the first semiconductor element. The filling layer wraps the first semiconductor element and the second semiconductor element. The transparent conductive layer is disposed on the filling layer. The transparent conductive layer electrically connects the first semiconductor element and the second semiconductor element. The first metal layer is disposed under the filling layer and includes a first portion and a second portion. The first portion is electrically connected to at least one of the first semiconductor element and the second semiconductor element. The second portion is disposed on a side surface of the filling layer.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1 is a schematic top view of a semiconductor chip according to an embodiment of the disclosure.
FIG. 2 is a schematic cross-sectional view of the semiconductor chip of FIG. 1 along a section line A-A'.
FIG. 3 is a circuit diagram of the semiconductor chip of FIG. 2.
FIG. 4 is a cross-sectional view of another embodiment of the semiconductor chip of FIG. 1 along a section line A-A'.
FIG. 5 is a circuit diagram of the semiconductor chip of FIG. 4.
FIG. 6 is a schematic cross-sectional view of a semiconductor chip of another embodiment of FIG. 1 along the section line A-A'.
FIG. 7 is a schematic cross-sectional view of another embodiment of the semiconductor chip of FIG. 1 along the section line A-A'.
FIG. 8A is a schematic top view of a semiconductor chip according to another embodiment of the disclosure.
FIG. 8B is a schematic cross-sectional view of the semiconductor chip of FIG. 8A along a section line B-B'.
FIG. 8C is a schematic cross-sectional view of the semiconductor chip of FIG. 8A along a section line C-C'.
FIG. 8D is a schematic cross-sectional view of the semiconductor chip of FIG. 8A along a section line D-D'.
FIG. 9 is a circuit diagram of the semiconductor chips of FIG. 8A to FIG. 8D.
FIG. 10A is a schematic cross-sectional view of another embodiment of the semiconductor chip of FIG. 8A along a section line B-B'.
FIG. 10B is a schematic cross-sectional view of another embodiment of the semiconductor chip of FIG. 8A along a section line D-D'.
FIG. 11A is a schematic cross-sectional view of another embodiment of the semiconductor chip of FIG. 8A along the section line B-B'.
FIG. 11B is a schematic cross-sectional view of another embodiment of the semiconductor chip of FIG. 8A along the section line D-D'.
FIG. 12A is a schematic top view of a semiconductor chip according to another embodiment of the disclosure.
FIG. 12B is a schematic cross-sectional view of the semiconductor chip of FIG. 12A along a section line E-E'.
FIG. 12C is a schematic cross-sectional view of the semiconductor chip of FIG. 12A along a section line F-F'.
FIG. 13 is a circuit diagram of the semiconductor chips of FIG. 12A to FIG. 12C.
FIG. 14A is a schematic top view of a semiconductor chip according to another embodiment of the disclosure.
FIG. 14B is a schematic cross-sectional view of the semiconductor chip of FIG. 14A along a section line G-G'.
FIG. 14C is a schematic cross-sectional view of the semiconductor chip of FIG. 14A along a section line H-H'.
FIG. 15 is a schematic cross-sectional view of an electronic device according to an embodiment of the disclosure.
FIG. 16 is a schematic cross-sectional view of an electronic device according to another embodiment of the disclosure.
FIG. 17 is a schematic cross-sectional view of an electronic device according to another embodiment of the disclosure.
FIG. 18 is an application of an electronic device according to another embodiment of the disclosure.

### DESCRIPTION OF THE EMBODIMENTS

The disclosure may be understood by referring to the following detailed description with reference of the accompanying drawings. It should be noted that in order to make it easier for readers to understand and for the simplicity of the drawings, the multiple drawings in the disclosure only depict a portion of the electronic device, and the specific elements in the drawings are not drawn according to an actual scale. In addition, the number and size of each element in the drawings are only for illustration and are not intended to limit the scope of the disclosure.

In the following description and claims, the terms "have", "include", etc., are openended words, so they should be interpreted as "including but not limited to...".

It should be understood that when an element or film layer is referred to as being "on" or "connected" to another element or film layer, the element or film layer may be directly on the other element or film layer, or directly connected to the other element or film layer, or there is an intervening element or film layer there between (an indirect situation). Conversely, when an element or film layer is referred to be "directly" on or "directly connected" to another element or film layer, there is no intervening element or film layer there between.

Although the terms "first", "second", "third"... may be used to describe various components, the components are not limited to these terms. These terms are only used to distinguish a single component from other components in the specification. The same terms may not be used in the claims, and the components may be described as first, second, third components... according to an order declared in the claims. Therefore, in the following description, the first component may be the second component in the claims.

In the text, the terms "about", "approximately", "substantially", and "roughly" generally mean within 10%, 5%, 3%, 2%, 1%, or 0.5% of a given value or range. The numbers given here are approximate numbers, i.e., in the absence of specific descriptions of "about", "approximately", "substantially", and "roughly", the meanings of "about", "approximately", "substantially", and "roughly" may still be implied.

Terms related to bonding and connecting mentioned in the specification, such as "connected", "interconnected", etc., unless specifically defined, may mean that two structures are in direct contact with each other, or that two structures are not in direct contact with each other, but there are other structures located between the above two structures. The terms of bonding and connecting may also include a situation that both structures are movable or both structures are fixed. In addition, the term "couple" includes any direct and indirect electrical connection means.

In some embodiments of the disclosure, an optical microscope (OM), a scanning electron microscope (SEM), an α-step, an ellipsometer, or other suitable methods may be used to measure an area, width, thickness, or height of each element, or a distance or spacing between elements. Specifically, according to some embodiments, an SEM may be used to obtain a cross-sectional structural image including the elements to be measured, and measure an area, width, thickness, or height of each element, or a distance or spacing between elements.

In the disclosure, a semiconductor chips may be used in an electronic device. The electronic device may include a display device, a light-emitting device, a backlight device, a virtual reality device, an augmented reality (AR) device, an antenna device, a sensing device, a splicing device, or any combination thereof, but the disclosure is not limited thereto. The display device may be a non-self-luminous display or a self-luminous display as required, and may be a color display or a monochrome display as required. The antenna device may be a liquid crystal type antenna device or a non-liquid crystal type antenna device, the sensing device may be a sensing device for sensing capacitance, light, heat or ultrasound, and the splicing device may be a display splicing device or an antenna splicing device, but the disclosure is not limited thereto. The electronic components in the electronic device may include passive components and active components, such as capacitors, resistors, inductors, diodes, transistors, etc. The diode may include a light emitting diode (LED) or a photodiode. The light emitting diode may include, for example, an organic light emitting diode (OLED), a mini LED, a micro LED, or a quantum dot LED, but the disclosure is not limited thereto. The transistor may include, for example, a top gate thin film transistor, a bottom gate thin film transistor, or a dual gate thin film transistor, but the disclosure is not limited thereto. The electronic device may also include a fluorescence material, a phosphor material, a quantum dot (QD) material, or other suitable materials according to actual requirements, but the disclosure is not limited thereto. The electronic device may have peripheral systems such as a driving system, a control system, a light source system, etc., to support a display device, an antenna device, a wearable device (for example, including an augmented reality or virtual reality device), an in-vehicle device (for example, including a car windshield), or a splicing device. It should be noted that the electronic device may be any combination of the aforementioned devices, but the disclosure is not limited thereto. The following will illustrate the disclosure by using a semiconductor chip in an electronic device, but the disclosure is not limited thereto.

It should be noted that in the following embodiments, features in several different embodiments may be replaced, reorganized, or mixed to complete other embodiments without departing from the spirit of the disclosure. The features between the embodiments may be arbitrarily mixed and matched as long as they do not violate the spirit of the disclosure or conflict with each other.

Reference will now be made in detail to the present preferred embodiments of the disclosure, examples of which are illustrated in the accompanying drawings. Wherever possible, the same reference numbers are used in the drawings and the description to refer to the same or like parts.

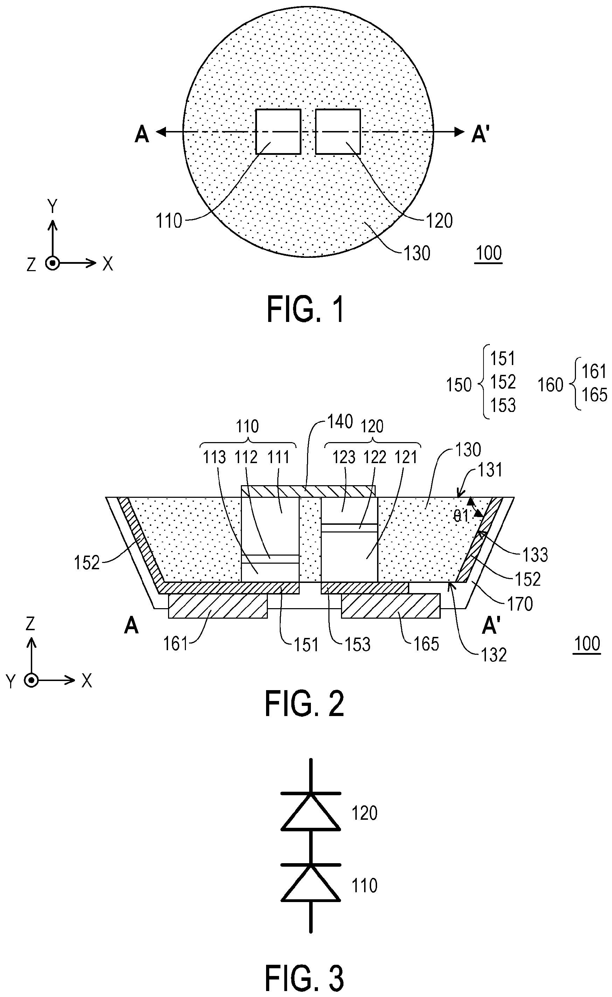

FIG. 1 is a schematic top view of a semiconductor chip according to an embodiment of the disclosure. FIG. 2 is a schematic cross-sectional view of the semiconductor chip of FIG. 1 along a section line A-A'. FIG. 3 is a circuit diagram of the semiconductor chip of FIG. 2. For the sake of clarity and convenience of description, FIG. 1 omits some components (for example, a transparent conductive layer 140, aa first metal layer 150, a second metal layer 160, and an insulating layer 170) in the semiconductor chip 100.

Referring to FIG. 1 and FIG. 2 at the same time, a semiconductor chip 100 of the embodiment includes a first semiconductor element 110, a second semiconductor element 120, a filling layer 130, a transparent conductive layer 140, a first metal layer 150, a second metal layer 160, and an insulating layer 170.

Specifically, in a direction Z (for example, a normal direction of the semiconductor chip 100), the first semiconductor element 110 includes, from top to bottom, a first type semiconductor layer 111, a light-emitting layer 112, and a second type semiconductor layer 113. The first type semiconductor layer 111 is closer to the transparent conductive layer 140 than the second type semiconductor layer 113, and the light-emitting layer 112 is disposed between the first type semiconductor layer 111 and the second type semiconductor layer 113.

The second semiconductor element 120 is adjacent to the first semiconductor element 110 in a direction X (for example, an extending direction of a section line A-A'). In the direction Z, the second semiconductor element 120 includes, from top to bottom, a second type semiconductor layer 123, a light-emitting layer 122, and a first type semiconductor layer 121. The second type semiconductor layer 123 is closer to the transparent conductive layer 140 than the first type semiconductor layer 121, and the light-emitting layer 122 is disposed between the second type semiconductor layer 123 and the first type semiconductor layer 121. Namely, the second semiconductor element 120 may be regarded as the first semiconductor element 110 with an opposite or inverted polarity direction. In the disclosure, the "polarity direction" may be, for example, a direction from the first type semiconductor layer to the second type semiconductor layer in the semiconductor element, but the disclosure is not limited thereto. In the disclosure, "adjacent" means that there are no other identical elements between two adjacent identical elements, for example, there are no other semiconductor elements between two adjacent semiconductor elements, but the disclosure is not limited thereto.

In the embodiment, direction X, direction Y, and direction Z are different directions. For example, the direction X is, for example, an extending direction of the section line A-A', and the direction Z is, for example, a normal direction of the semiconductor chip 100. The direction X and the direction Z are respectively perpendicular to the direction Y, and the direction X is perpendicular to the direction Z, but the disclosure is not limited thereto.

In the embodiment, the first semiconductor element 110 and the second semiconductor element 120 may be light emitting elements (for example, organic LEDs, mini-LEDs, micro-LEDs or quantum dot LEDs, but the disclosure is not limited thereto), and the first semiconductor element 110 and the second semiconductor element 120 may be respectively used to emit light of a same wavelength, but the disclosure is not limited thereto. In the disclosure, the wavelength of light is defined as a wavelength corresponding to the maximum intensity in a spectrum of the light. In addition, the same wavelength is defined as that a difference between two wavelengths is less than 5%. In the embodiment, the first type semiconductor layer 111 and the first type semiconductor layer 121 may be N-type semiconductor layers, and the second type semiconductor layer 113 and the second type semiconductor layer 123 may be P-type semiconductor layers, but the disclosure is not limited thereto. In some embodiments, the first type semiconductor layer 111 and the first type semiconductor layer 121 may also be P-type semiconductor layers, and the second type semiconductor layer 113 and the second type semiconductor layer 123 may also be N-type semiconductor layers.

The filling layer 130 wraps the first semiconductor element 110 and the second semiconductor element 120 to combine the first semiconductor element 110 and the second semiconductor element 120. The filling layer 130 has an upper surface 131, a lower surface 132, and a side surface 133. The upper surface 131 and the lower surface 132 are opposite to each other, and the side surface 133 connects the upper surface 131 and the lower surface 132. An included angle θ1 between the upper surface 131 and the side surface 133 is a taper angle. In the embodiment, the included angle θ1 may be between 10 degrees and 80 degrees, or between 30 degrees and 70 degrees, to improve light extraction efficiency or reduce (concentrate) a light emitting angle, but the disclosure is not limited thereto. The filling layer 130 may have a transmittance greater than 90% for visible light. The material of the filler layer 130 may include acrylic, epoxy, siloxane, silica, other transparent filler materials, or a combination thereof, but the disclosure is not limited thereto.

The transparent conductive layer 140 is disposed on the upper surface 131 of the filling layer 130. The transparent conductive layer 140 electrically connects the first semiconductor element 110 and the second semiconductor element 120. The transparent conductive layer 140 may be electrically connected to the first type semiconductor layer 111 of the first semiconductor element 110 and the second type semiconductor layer 123 of the second semiconductor element 120. A material of the transparent conductive layer 140 may include transparent conductive oxides (TCO) or metal, but the disclosure is not limited thereto. A material of the transparent conductive oxide may include indium tin oxide (ITO), indium zinc oxide (IZO) or indium gallium oxide (IGO) or a combination thereof, but the disclosure is not limited thereto.

The first metal layer 150 is disposed under the lower surface 132 and on the side surface 133 of the filling layer 130. The first metal layer 150 and the transparent conductive layer 140 may be separated from each other, but the disclosure is not limited thereto. The first metal layer 150 includes a first portion 151, a second portion 152, and a third portion 153. Specifically, the first portion 151 is disposed under the lower surface 132 of the filling layer 130. The first portion 151 may be electrically connected to at least one of the first semiconductor element 110 and the second semiconductor element 120. For example, in the embodiment, the first portion 151 may be electrically connected to the second type semiconductor layer 113 of the first semiconductor element 110, but the disclosure is not limited thereto. The second portion 152 is disposed on the side surface 133 of the filling layer 130. The second portion 152 may be a material having a high reflective property to improve optical efficiency. The second portion 152 may be connected to the first portion 151. The third portion 153 is disposed under the lower surface 132 of the filling layer 130. The third portion 153 is separated from the first portion 151, and the third portion 153 is separated from the second portion 152, but the disclosure is not limited thereto. The third portion 153 may be electrically connected to the first type semiconductor layer 121 of the second semiconductor element 120. In some embodiments not shown, the second portion 152 and the first portion 151 are separated from each other, the third portion 153 and the first portion 151 are separated from each other, and the third portion 153 may be connected to the second portion 152.

The second metal layer 160 is disposed under the first metal layer 150. The second metal layer 160 includes a first type electrode 161 and a second type electrode 165. The first type electrode 161 contacts and is electrically connected to the first portion 151, and the second type electrode 165 contacts and is electrically connected to the third portion 153. A material of the second metal layer 160 may include gold, tin, copper, other suitable electrode materials, or a combination thereof, but the disclosure is not limited thereto. In the embodiment, the material of the second metal layer 160 may be the same as or different from the material of the first metal layer 150. In the embodiment, the first type electrode 161 may be a P-type electrode, and the second type electrode 165 may be an N-type electrode, but the disclosure is not limited thereto. In some embodiments, the first type electrode 161 may also be an N-type electrode, and the second type electrode 165 may also be a P-type electrode. A P-type electrode refers to an electrode electrically connected to a P-type semiconductor layer, and an N-type electrode refers to an electrode electrically connected to an N-type semiconductor layer.

The insulating layer 170 is disposed under the first metal layer 150. The insulating layer 170 may wrap the first metal layer 150. A material of the insulating layer 170 may include acrylic, epoxy, siloxane, silicon dioxide, silicon nitride, silicon oxynitride, other suitable insulating materials or a combination thereof, but the disclosure is not limited thereto.

Referring to FIG. 2 and FIG. 3 at a same time, in the semiconductor chip 100 of the embodiment, the first semiconductor element 110 and the second semiconductor element 120 implement configuration and circuit connection in a serial manner (i.e., the second type semiconductor layer 113 of the first semiconductor element 110 is electrically connected to the first type electrode 161, the first type semiconductor layer 111 of the first semiconductor element 110 is electrically connected to the second type semiconductor layer 123 of the second semiconductor element 120, and the first type semiconductor layer 121 of the second semiconductor element 120 is electrically connected to the second type electrode 165), but the disclosure is not limited thereto. In the embodiment, since the first semiconductor element 110 and the second semiconductor element 120 integrated in the same semiconductor chip 100 are connected in series, a voltage across the first semiconductor element 110 and the second semiconductor element 120 may be concentrated, and waste of voltage across the transistor may be reduced, thereby reducing power consumption.

In the embodiment, since the first type electrode 161 and the second type electrode 165 electrically connected to the vertical type first semiconductor element 110 (or second semiconductor element 120) are both arranged on a same side of the semiconductor chip 100, the semiconductor chip 100 of the embodiment may be regarded as a vertical embedded flip-chip (VEFC), but the disclosure is not limited thereto. In addition, compared to a semiconductor chip in which the first type electrode and the second type electrode are disposed on different sides, the semiconductor chip 100 of the embodiment is suitable for performing electrical test after transfer by disposing the first type electrode 161 and the second type electrode 165 on the same side.

Although the semiconductor chip 100 of the embodiment is an example of integrating two semiconductor elements (i.e., the first semiconductor element 110 and the second semiconductor element 120) in series, the disclosure does not limit a number of the semiconductor elements integrated by the semiconductor chip and the circuit connection method. In other words, in some embodiments, the number of the semiconductor elements integrated by the semiconductor chip may also be 3 or more. In some embodiments, the semiconductor elements integrated by the semiconductor chip may also implement configuration and circuit connection in a parallel manner or a serial-parallel manner.

Other embodiments will be listed below for illustration. It should be noticed that reference numbers of the components and a part of contents of the aforementioned embodiment are also used in the following embodiment, where the same reference numbers denote the same or like components, and descriptions of the same technical contents are omitted. The aforementioned embodiment may be referred for descriptions of the omitted parts, and detailed descriptions thereof are not repeated in the following embodiment.

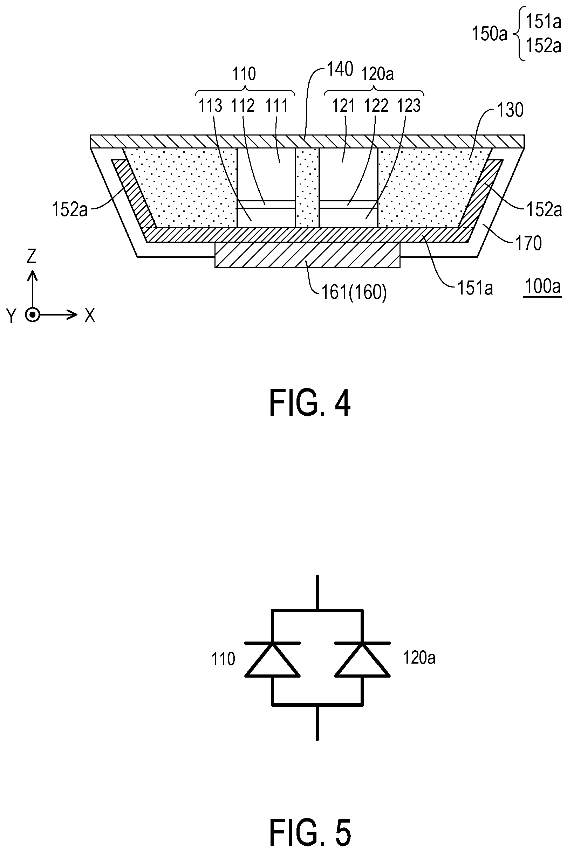

FIG. 4 is a cross-sectional view of another embodiment of the semiconductor chip of FIG. 1 along a section line A-A'. FIG. 5 is a circuit diagram of the semiconductor chip of FIG. 4. Referring to FIG. 4 to FIG. 5 and FIG. 1 to FIG. 3 at the same time, a semiconductor chip 100a of the embodiment is similar to the semiconductor chip 100 of FIG1 to FIG3, but a difference there between is that in the semiconductor chip 100a of the embodiment, the first semiconductor element 110 and the second semiconductor element 120a implement configuration and circuit connection in a parallel manner.

Specifically, referring to FIG. 4, in the direction Z (for example, a normal direction of the semiconductor chip 100a), the second semiconductor element 120a includes, from top to bottom, a first type semiconductor layer 121, a light-emitting layer 122, and a second type semiconductor layer 123, and the first type semiconductor layer 121 is closer to the transparent conductive layer 140 than the second type semiconductor layer 123. In other words, the second semiconductor element 120a and the first semiconductor element 110 have a same polarity direction.

The transparent conductive layer 140 and the first metal layer 150a may be separated from each other. The transparent conductive layer 140 is electrically connected to the first type semiconductor layer 111 of the first semiconductor element 110 and the first type semiconductor layer 121 of the second semiconductor element 120a. In the embodiment, the transparent conductive layer 140 may be regarded as a second type electrode.

The first metal layer 150a includes a first portion 151a and a second portion 152a, and the first portion 151a may be connected to the second portion 152a. The first portion 151a may be electrically connected to at least one of the second type semiconductor layer 113 of the first semiconductor element 110 and the second type semiconductor layer 123 of the second semiconductor element 120a. For example, in the embodiment, the first portion 151a may be electrically connected to the second type semiconductor layer 113 of the first semiconductor element 110 and the second type semiconductor layer 123 of the second semiconductor element 120a, but the disclosure is not limited thereto.

Referring to FIG. 4 and FIG. 5 at the same time, in the semiconductor chip 100a of the embodiment, the first semiconductor element 110 and the second semiconductor element 120a implement configuration and circuit connection in a parallel manner (i.e., the second type semiconductor layer 113 of the first semiconductor element 110 and the second type semiconductor layer 123 of the second semiconductor element 120a are both electrically connected to the first type electrode 161, and the first type semiconductor layer 111 of the first semiconductor element 110 and the first type semiconductor layer 121 of the second semiconductor element 120a are both electrically connected to the second type electrode). In the embodiment, since the first semiconductor element 110 and the second semiconductor element 120a integrated in the same semiconductor chip 100a implement configuration and circuit connection in the parallel manner, when one of the semiconductor elements (such as the first semiconductor element 110) is damaged, the other semiconductor element (such as the second semiconductor element 120a) may still operate normally without affecting the normal function of the semiconductor chip 100a, thereby reducing the defect rate or cost of repair.

In the embodiment, since the first type electrode 161 and the second type electrode (i.e., the transparent conductive layer 140) electrically connected to the vertical first semiconductor element 110 (or the second semiconductor element 120a) are respectively disposed on two opposite sides of the semiconductor chip 100a, the semiconductor chip 100a of the embodiment may be regarded as a vertical embedded chip (VEC), but the disclosure is not limited thereto.

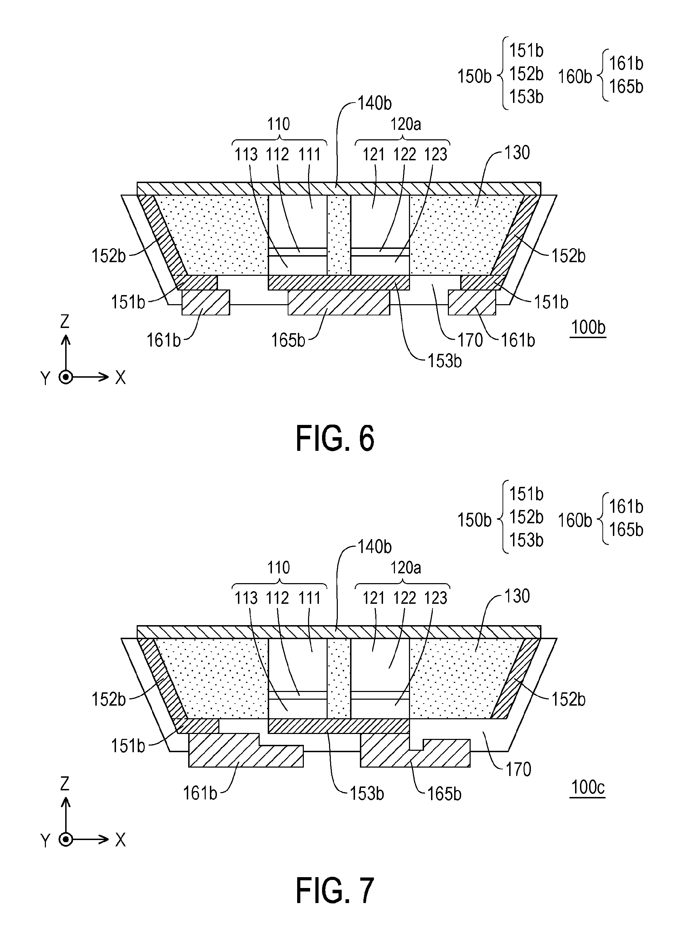

FIG. 6 is a schematic cross-sectional view of a semiconductor chip of another embodiment of FIG. 1 along the section line A-A'. Referring to FIG. 6 and FIG. 4 to FIG. 5 at the same time, a semiconductor chip 100b of the embodiment is similar to the semiconductor chip 100a of FIG. 4 to FIG. 5, and a difference there between is that in the semiconductor chip 100b of the embodiment, the transparent conductive layer 140b may be connected to the first metal layer 150b.

Specifically, referring to FIG. 6, the first metal layer 150b includes a first portion 151b, a second portion 152b, and a third portion 153b. Specifically, since the first portion 151b may be connected to the second portion 152b, and the second portion 152b may be connected to the transparent conductive layer 140b, the first portion 151b may be electrically connected to the first type semiconductor layer 111 of the first semiconductor element 110 and the first type semiconductor layer 121 of the second semiconductor element 120a through the second portion 152b and the transparent conductive layer 140b.

The third portion 153b is separated from the first portion 151b, and the third portion 153b is separated from the second portion 152b. The third portion 153b may be electrically connected to at least one of the second type semiconductor layer 113 of the first semiconductor element 110 and the second type semiconductor layer 123 of the second semiconductor element 120a. For example, in the embodiment, the third portion 153b may be electrically connected to the second type semiconductor layer 113 of the first semiconductor element 110 and the second type semiconductor layer 123 of the second semiconductor element 120a.

The second metal layer 160b includes a first type electrode 161b and a second type electrode 165b. The first type electrode 161b contacts and is electrically connected to the first portion 151b, and the second type electrode 165b contacts and is electrically connected to the third portion 153b.

In the embodiment, since the first semiconductor element 110 and the second semiconductor element 120a integrated in the same semiconductor chip 100b implement configuration and circuit connection through a parallel manner (i.e., the second type semiconductor layer 113 of the first semiconductor element 110 and the second type semiconductor layer 123 of the second semiconductor element 120a are both electrically connected to the second type electrode 165b, and the first type semiconductor layer 111 of the first semiconductor element 110 and the first type semiconductor layer 121 of the second semiconductor element 120a are both electrically connected to the first type electrode 161b), so that when one of the semiconductor elements (such as the first semiconductor element 110) is damaged, the other semiconductor element (such as the second semiconductor element 120a) may still operate normally without affecting the normal function of the semiconductor chip 100b, thereby reducing the defect rate or cost of repair.

In the embodiment, since the first type electrode 161b and the second type electrode 165b electrically connected to the vertical first semiconductor element 110 (or second semiconductor element 120a) are both disposed on a same side of the semiconductor chip 100b, the semiconductor chip 100b of the embodiment may be regarded as a vertical embedded flip chip.

In the cross-sectional view of FIG. 6, when a vertical line through a midpoint between the first semiconductor element 110 and the second semiconductor element 120a is used as an axis of symmetry, the semiconductor chips 100b (or first type electrodes 161b) on the left and right sides may be symmetrically arranged, thereby enabling the semiconductor chip 100b of the embodiment to be suitable for transferring by fluid transfer.

FIG. 7 is a schematic cross-sectional view of another embodiment of the semiconductor chip of FIG. 1 along the section line A-A'. Referring to FIG. 7 and FIG. 6 at the same time, a semiconductor chip 100c of the embodiment is similar to the semiconductor chip 100b of FIG. 6, and a difference there between is that in the semiconductor chip 100c of the embodiment, the semiconductor chip 100c on the left and right sides is not symmetrically arranged, and the semiconductor chip 100c may be transferred by heat pressing or laser.

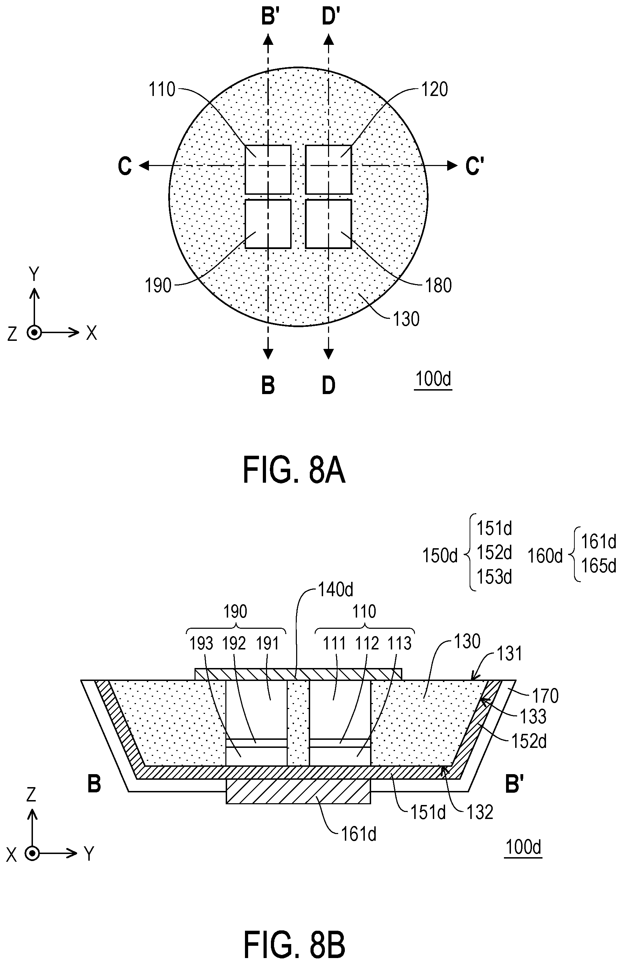

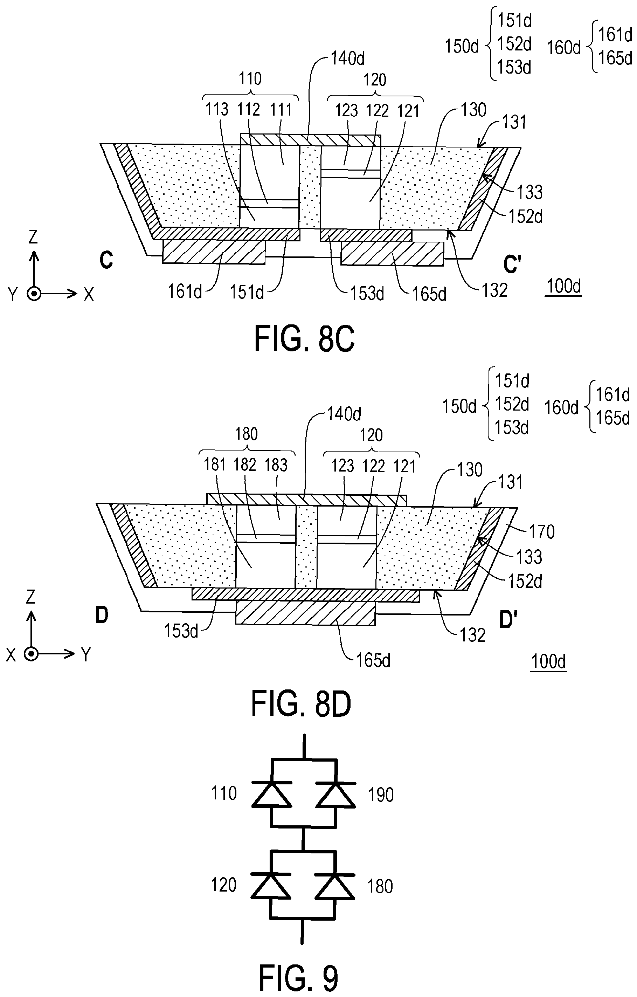

FIG. 8A is a schematic top view of a semiconductor chip according to another embodiment of the disclosure. FIG. 8B is a schematic cross-sectional view of the semiconductor chip of FIG. 8A along a section line B-B'. FIG. 8C is a schematic cross-sectional view of the semiconductor chip of FIG. 8A along a section line C-C'. FIG. 8D is a schematic cross-sectional view of the semiconductor chip of FIG. 8A along a section line D-D'. FIG. 9 is a circuit diagram of the semiconductor chips of FIG. 8A to FIG. 8D. For the sake of clarity and convenience of description, FIG. 8A omits showing some components in the semiconductor chip 100d (for example, the transparent conductive layer 140d, the first metal layer 150d, and the second metal layer 160d). Referring to FIG. 1 to FIG. 2 and FIG. 8A to FIG. 8D at the same time, the semiconductor chip 100d of the embodiment is similar to the semiconductor chip 100 of FIG. 1 to FIG. 2, and a difference there between is that the semiconductor chip 100d of the embodiment further includes a third semiconductor element 180 and a fourth semiconductor element 190.

Specifically, referring to FIG. 8A to FIG. 8D, the third semiconductor element 180 is adjacent to the second semiconductor element 120 in the direction Y (for example, an extending direction of the section line D-D'). In the direction Z (for example, a normal direction of the semiconductor chip 100d), the third semiconductor element 180 includes, from top to bottom, a second type semiconductor layer 183, a light-emitting layer 182, and a first type semiconductor layer 181. The second type semiconductor layer 183 is closer to the transparent conductive layer 140d than the first type semiconductor layer 181. Namely, the third semiconductor element 180 and the second semiconductor element 120 have the same polarity direction, and the third semiconductor element 180 and the first semiconductor element 110 have different polarity directions.

The fourth semiconductor element 190 is adjacent to the first semiconductor element 110 in the direction Y, and the fourth semiconductor element 190 is adjacent to the third semiconductor element 180 in the direction X. In the direction Z, the fourth semiconductor element 190 includes, from top to bottom, a first type semiconductor layer 191, a light-emitting layer 192, and a second type semiconductor layer 193. The first type semiconductor layer 191 is closer to the transparent conductive layer 140d than the second type semiconductor layer 193. Namely, the fourth semiconductor element 190 has the same polarity direction as the first semiconductor element 110, and the fourth semiconductor element 190 has a different polarity direction from the second semiconductor element 120.

The transparent conductive layer 140d and the first metal layer 150d may be separated from each other. The transparent conductive layer 140d may be electrically connected to the first type semiconductor layer 111 of the first semiconductor element 110, the second type semiconductor layer 123 of the second semiconductor element 120, the second type semiconductor layer 183 of the third semiconductor element 180, and the first type semiconductor layer 191 of the fourth semiconductor element 190.

The first portion 151d of the first metal layer 150d may be electrically connected to the second type semiconductor layer 113 of the first semiconductor element 110 and the second type semiconductor layer 193 of the fourth semiconductor element 190. The second portion 152d may be connected to the first portion 151d. The third portion 153d may be electrically connected to the first type semiconductor layer 121 of the second semiconductor element 120 and the first type semiconductor layer 181 of the third semiconductor element 180. The third portion 153d is separated from the first portion 151d, and the third portion 153d is separated from the second portion 152d.

The first type electrode 161d of the second metal layer 160d contacts and is electrically connected to the first portion 151d, and the second type electrode 165d contacts and is electrically connected to the third portion 153d.

In the embodiment, the first semiconductor element 110, the second semiconductor element 120, the third semiconductor element 180, and the fourth semiconductor element 190 may be respectively configured to emit light of the same wavelength, but the disclosure is not limited thereto.

Referring to FIG. 8A to FIG. 8D and FIG. 9, the semiconductor chip 100d of the embodiment integrates the first semiconductor element 110, the second semiconductor element 120, the third semiconductor element 180 and the fourth semiconductor element 190; where the first semiconductor element 110 and the second semiconductor element 120 implement configuration and circuit connection in a serial manner, and the third semiconductor element 180 and the fourth semiconductor element 190 implement configuration and circuit connection in the serial manner, thereby concentrating the voltage across the semiconductor element instead of the transistor, so as to reduce power consumption. The first semiconductor element 110 and the fourth semiconductor element 190 implement configuration and circuit connection in a parallel manner, and the second semiconductor element 120 and the third semiconductor element 180 implement configuration and circuit connection in the parallel manner, so that when one of the semiconductor elements (such as the first semiconductor element 110) is damaged, the other semiconductor element (such as the fourth semiconductor element 190) may still operate normally without affecting the normal function of the semiconductor chip 100d, thereby reducing the defect rate or the cost of repair.

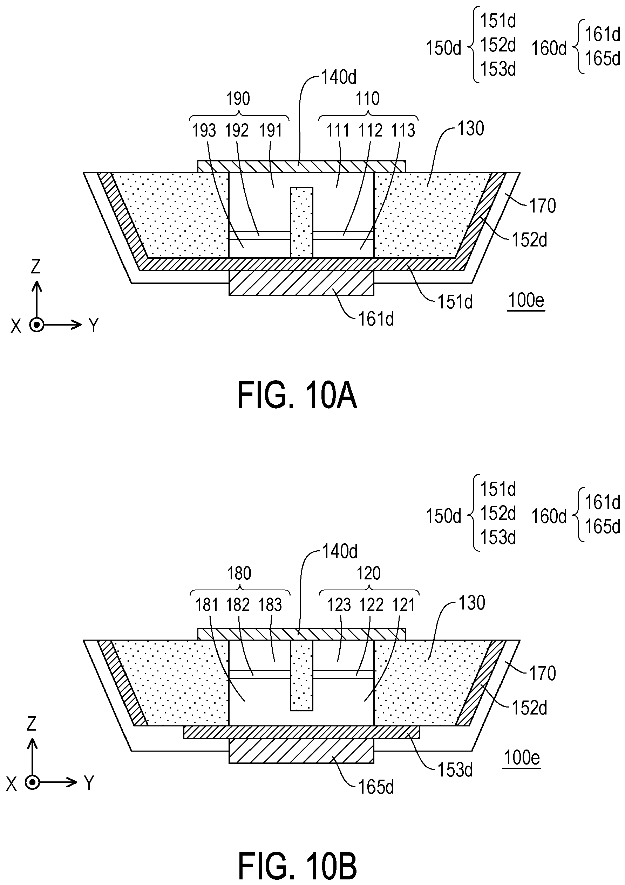

FIG. 10A is a schematic cross-sectional view of another embodiment of the semiconductor chip of FIG. 8A along a section line B-B'. FIG. 10B is a schematic cross-sectional view of another embodiment of the semiconductor chip of FIG. 8A along a section line D-D'. Referring to FIG. 10A to FIG. 10B and FIG. 8A to FIG. 8D at the same time, a semiconductor chip 100e of the embodiment is similar to the semiconductor chip 100d of FIG. 8A to FIG. 8D, and a difference there between is that: in the semiconductor chip 100e of the embodiment, the first type semiconductor layer 111 of the first semiconductor element 110 is partially connected to the first type semiconductor layer 191 of the fourth semiconductor element 190, and the first type semiconductor layer 121 of the second semiconductor element 120 is partially connected to the first type semiconductor layer 181 of the third semiconductor element 180, thereby making it easier to transfer the semiconductor elements.

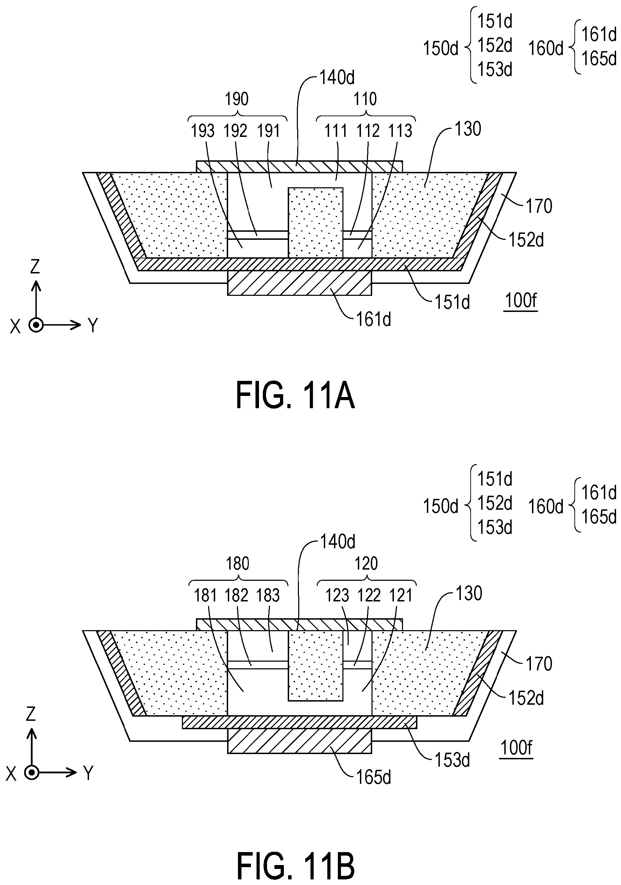

FIG. 11A is a schematic cross-sectional view of another embodiment of the semiconductor chip of FIG. 8A along the section line B-B'. FIG. 11B is a schematic cross-sectional view of another embodiment of the semiconductor chip of FIG. 8A along the section line D-D'. Referring to FIG. 11A to FIG. 11B and FIG. 10A to FIG. 10B at the same time, a semiconductor chip 100f of the embodiment is similar to the semiconductor chip 100e of FIG. 10A to FIG. 10B, and a difference there between is that: in the semiconductor chip 100f of the embodiment, in the direction Z (for example, a normal direction of the semiconductor chip 100f), a projection area of the fourth semiconductor element 190 is larger than a projection area of the first semiconductor element 110, and a projection area of the third semiconductor element 180 is larger than a projection area of the second semiconductor element 120, so that the fourth semiconductor element 190 and the first semiconductor element 110 may respectively have different photocurrent characteristics and luminous efficiency, and the third semiconductor element 180 and the second semiconductor element 120 may respectively have different photocurrent characteristics and luminous efficiency.

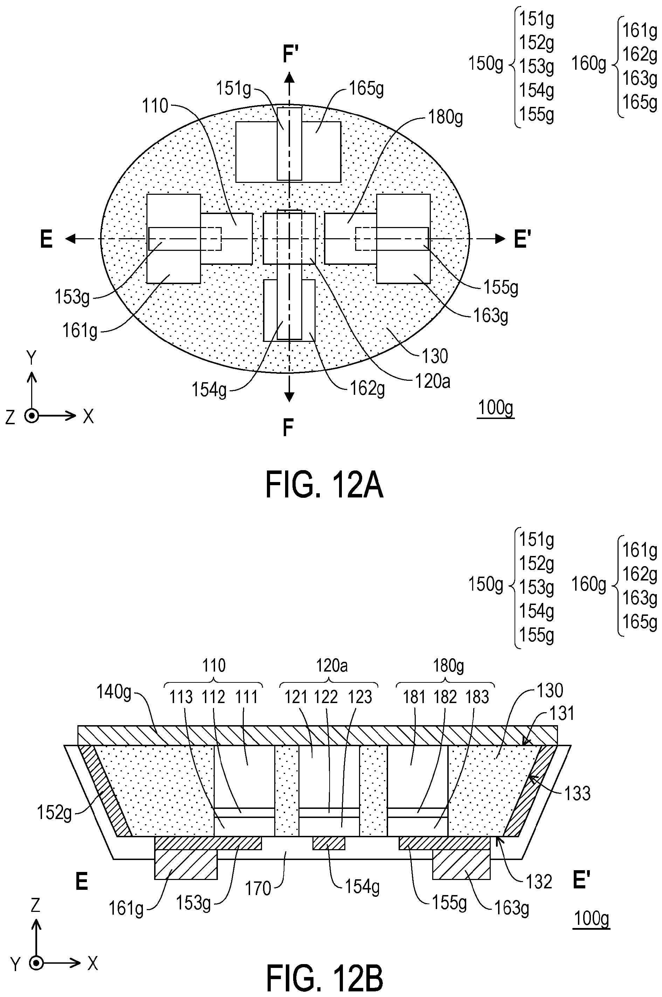

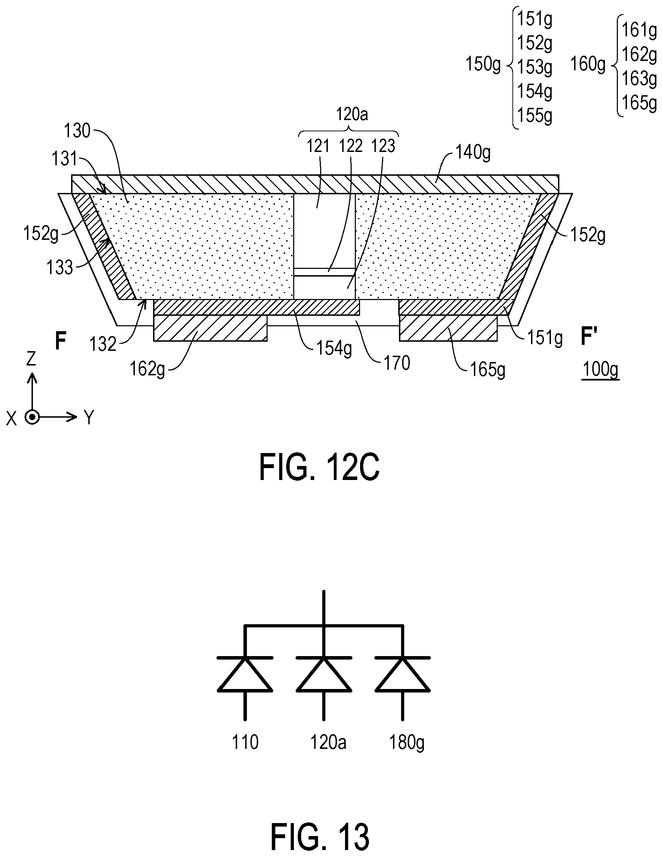

FIG. 12A is a schematic top view of a semiconductor chip according to another embodiment of the disclosure. FIG. 12B is a schematic cross-sectional view of the semiconductor chip of FIG. 12A along a section line E-E'. FIG. 12C is a schematic cross-sectional view of the semiconductor chip of FIG. 12A along a section line F-F'. FIG. 13 is a circuit diagram of the semiconductor chips of FIG. 12A to FIG. 12C. For the sake of clarity of the drawings and convenience of description, FIG. 12A omits showing some components (for example, a transparent conductive layer 140g) in a semiconductor chip 100g. Referring to FIG. 12A to FIG. 12C and FIG. 6 at the same time, the semiconductor chip 100g of the embodiment is similar to the semiconductor chip 100b of FIG. 6, and a difference there between is that the semiconductor chip 100g of the embodiment further includes a third semiconductor element 180g, and the first metal layer 150g further includes a fourth portion 154g and a fifth portion 155g.

Specifically, referring to FIG. 12A to FIG. 12C at the same time, in the direction X (for example, an extending direction of the section line E-E'), the third semiconductor element 180g is adjacent to the second semiconductor element 120a, and the second semiconductor element 120a is disposed between the first semiconductor element 110 and the third semiconductor element 180g. In the direction Z (for example, a normal direction of the semiconductor chip 100g), the third semiconductor element 180g includes, from top to bottom, a first type semiconductor layer 181, a light-emitting layer 182, and a second type semiconductor layer 183, and the first type semiconductor layer 181 is closer to the transparent conductive layer 140g than the second type semiconductor layer 183. In other words, the third semiconductor element 180g has the same polarity direction as the first semiconductor element 110 and the second semiconductor element 120a.

In the embodiment, the first semiconductor element 110, the second semiconductor element 120a and the third semiconductor element 180g may be respectively used to emit light of different wavelengths, such as red light, green light and blue light, but the disclosure is not limited thereto.

The transparent conductive layer 140g is electrically connected to the first type semiconductor layer 111 of the first semiconductor element 110, the first type semiconductor layer 121 of the second semiconductor element 120a, and the first type semiconductor layer 181 of the third semiconductor element 180g.

The first metal layer 150g includes a first portion 151g, a second portion 152g, a third portion 153g, a fourth portion 154g, and a fifth portion 155g. Specifically, the first portion 151g is disposed under the lower surface 132 of the filling layer 130, and the first portion 151g may be electrically connected to the transparent conductive layer 140g through the second portion 152g. The second portion 152g is disposed on the side surface 133 of the filling layer 130, and the second portion 152g may be connected to the first portion 151g. The third portion 153g is disposed under the lower surface 132 of the filling layer 130, and the third portion 153g may be electrically connected to the second type semiconductor layer 113 of the first semiconductor element 110. The fourth portion 154g is disposed under the lower surface 132 of the filling layer 130, and the fourth portion 154g may be electrically connected to the second type semiconductor layer 123 of the second semiconductor element 120a. The fifth portion 155g is disposed under the lower surface 132 of the filling layer 130, and the fifth portion 155g may be electrically connected to the second type semiconductor layer 183 of the third semiconductor element 180g. In the embodiment, the first portion 151g (or the second portion 152g), the third portion 153g, the fourth portion 154g, and the fifth portion 155g are separated from each other.

The second metal layer 160g includes a first type electrode 161g, a first type electrode 162g, a first type electrode 163g, and a second type electrode 165g that are separated from each other. The first type electrode 161g contacts and is electrically connected to the third portion 153g, the first type electrode 162g contacts and is electrically connected to the fourth portion 154g, the first type electrode 163g contacts and is electrically connected to the fifth portion 155g, and the second type electrode 165g contacts and is electrically connected to the first portion 151g. In addition, in the embodiment, the first type electrode 161g, the first type electrode 162g and the first type electrode 163g may be electrically separated from each other so that the first type electrode 161g, the first type electrode 162g and the first type electrode 163g may respectively and independently control the first semiconductor element 110, the second semiconductor element 120a and the third semiconductor element 180g, but the disclosure is not limited thereto.

In the embodiment, since the first type electrode 161g and the second type electrode 165g electrically connected to the vertical first semiconductor element 110 are both disposed on a same side of the semiconductor chip 100g, the semiconductor chip 100g of the embodiment may be regarded as a vertical embedded flip chip.

Compared to the general method of transferring semiconductor elements (i.e., the first semiconductor element 110, the second semiconductor element 120a, and the third semiconductor element 180g) for emitting light of different wavelengths to the circuit board by multiple times, the embodiment reduces the number of transfers required (i.e., the first semiconductor element 110, the second semiconductor element 120a, and the third semiconductor element 180g may be transferred to the circuit board at the same time in one transfer) by integrating the semiconductor elements (i.e., the first semiconductor element 110, the second semiconductor element 120a, and the third semiconductor element 180g) for emitting light of different wavelengths into the same semiconductor chip 100g, thereby improving the yield or productivity.

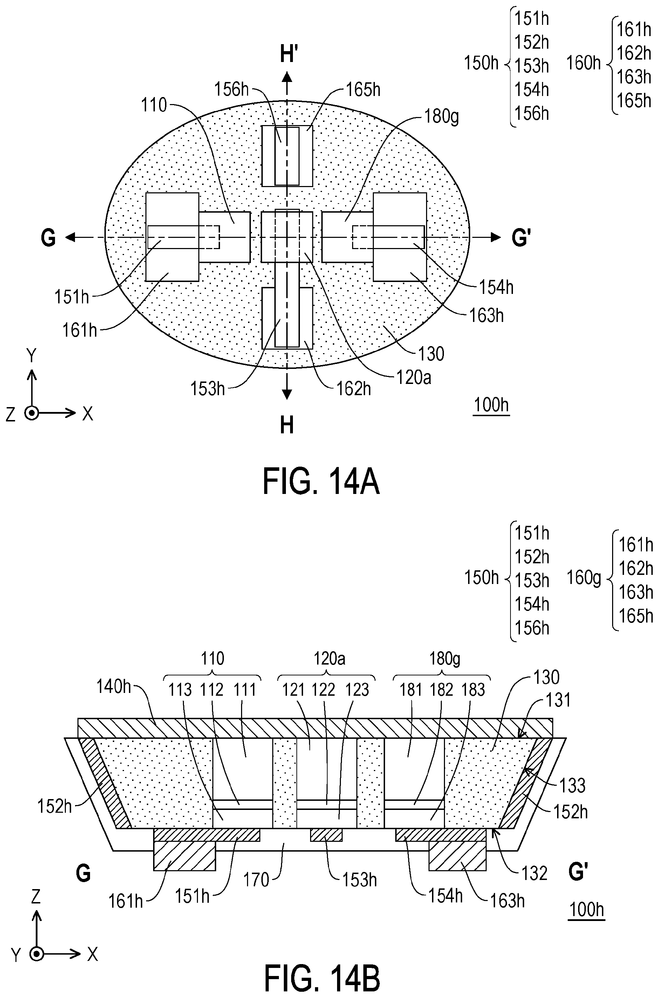

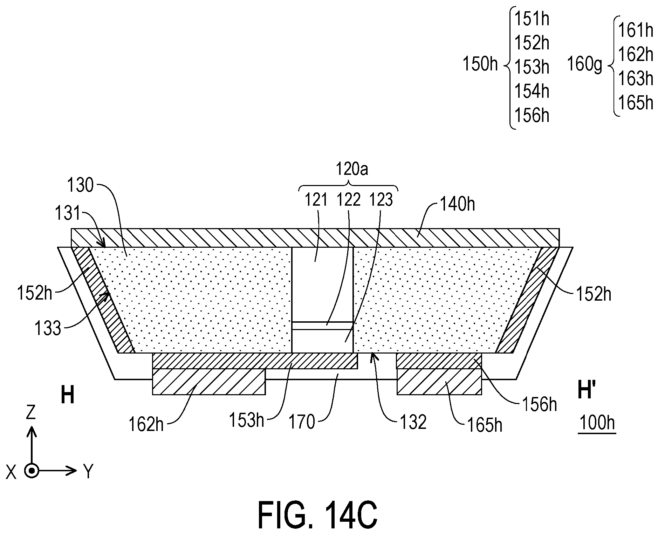

FIG. 14A is a schematic top view of a semiconductor chip according to another embodiment of the disclosure. FIG. 14B is a schematic cross-sectional view of the semiconductor chip of FIG. 14A along a section line G-G'. FIG. 14C is a schematic cross-sectional view of the semiconductor chip of FIG. 14A along a section line H-H'. FIG. 14A omits showing some components (for example, a transparent conductive layer 140h) in a semiconductor chip 100h. Referring to FIG. 14A to FIG. 14C and FIG. 12A to FIG. 12C at the same time, the semiconductor chip 100h of the embodiment is similar to the semiconductor chip 100g of FIG. 12A to FIG. 12C, and a difference there between is that in the semiconductor chip 100h of the embodiment, the second portion 152h of the first metal layer 150h and a redundant portion 156h are electrically insulated from each other.

Specifically, referring to FIG. 14A to FIG. 14C, the transparent conductive layer 140h is electrically connected to the first type semiconductor layer 111 of the first semiconductor element 110, the first type semiconductor layer 121 of the second semiconductor element 120a, and the first type semiconductor layer 181 of the third semiconductor element 180g. In the embodiment, the transparent conductive layer 140h may be regarded as a second type electrode.

The first metal layer 150h includes a first portion 151h, a second portion 152h, a third portion 153h, a fourth portion 154h, and a redundant portion 156h. Specifically, the first portion 151h is disposed under the lower surface 132 of the filling layer 130, and the first portion 151h is electrically connected to the second type semiconductor layer 113 of the first semiconductor element 110. The second portion 152h is disposed on the side surface 133 of the filling layer 130. The third portion 153h is disposed under the lower surface 132 of the filling layer 130, and the third portion 153h may be electrically connected to the second type semiconductor layer 123 of the second semiconductor element 120a. The fourth portion 154h is disposed under the lower surface 132 of the filling layer 130, and the fourth portion 154h may be electrically connected to the second type semiconductor layer 183 of the third semiconductor element 180g. The redundant portion 156h is disposed under the lower surface 132 of the filling layer 130. The redundant portion 156h is electrically insulated from the first semiconductor element 110, and the redundant portion 156h is electrically insulated from the second semiconductor element 120a, and is electrically insulated from the first semiconductor element 110 and the third semiconductor element 180g. In the embodiment, the first portion 151h, the second portion 152h, the third portion 153h, the fourth portion 154h, and the redundant portion 156h are separated from each other.

The second metal layer 160h includes a first type electrode 161h, a first type electrode 162h, a first type electrode 163h, and a bonding pad 165h which are separated from each other. The first type electrode 161h contacts and is electrically connected to the first portion 151h, the first type electrode 162h contacts and is electrically connected to the third portion 153h, the first type electrode 163h contacts and is electrically connected to the fourth portion 154h, and the bonding pad 165h contacts and is used to support the redundant portion 156h. In addition, in the embodiment, the first type electrode 161h, the first type electrode 162h and the first type electrode 163h may be electrically separated from each other so that the first type electrode 161h, the first type electrode 162h and the first type electrode 163h may respectively and independently control the first semiconductor element 110, the second semiconductor element 120a and the third semiconductor element 180g, but the disclosure is not limited thereto.

In the embodiment, since the first type electrode 161h and the second type electrode (i.e., the transparent conductive layer 140h) electrically connected to the vertical first semiconductor element 110 are respectively disposed on two opposite sides of the semiconductor chip 100h, the semiconductor chip 100h of the embodiment may be regarded as a vertical embedded chip.

In some embodiments that are not shown, the redundant portion may be connected to the third portion, and the redundant portion may be electrically connected to the second semiconductor element.

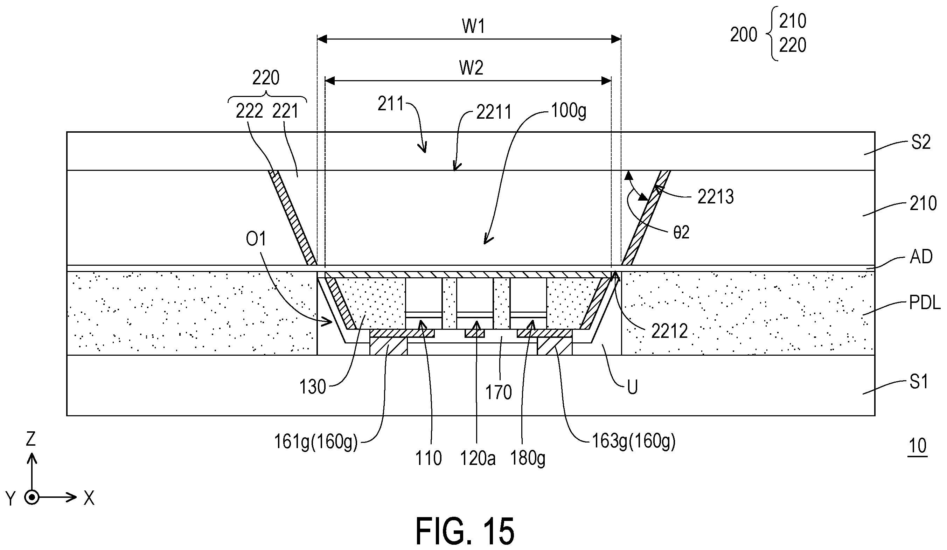

FIG. 15 is a schematic cross-sectional view of an electronic device according to an embodiment of the disclosure. Referring to FIG. 15, an electronic device 10 of the disclosure includes a circuit board S1, a pixel definition layer (PDL), a semiconductor chip 100g as shown in FIG. 12A to FIG. 12C, an underfill U, an adhesive layer AD, a light enhancement unit (LEU) 200, and a substrate S2.

Specifically, the circuit board S1 may include a circuit (not shown), and the circuit may include, for example, a thin film transistor element, a wire, an insulating layer, etc., but the disclosure is not limited thereto. In the embodiment, a material of the circuit board S1 may include a rigid substrate, a flexible substrate, or a combination thereof. For example, the material of the circuit board S1 may include glass, quartz, sapphire, ceramic, polycarbonate (PC), polyimide (PI), polyethylene terephthalate (PET), other suitable substrate materials, or a combination thereof, but the disclosure is not limited thereto.

The pixel definition layer PDL is disposed on the circuit board S1. The pixel definition layer PDL has an opening O1 that may expose the circuit board S1. A material of the pixel definition layer PDL may include organic photoresist, but the disclosure is not limited thereto. A color of the pixel definition layer PDL may be transparent, black, gray, or white, but the disclosure is not limited thereto.

The semiconductor chip 100g is disposed in the opening O1 of the pixel definition layer PDL. The semiconductor chip 100g may be bonded and electrically connected to the circuit board S1 through the second metal layer 160g.

The underfill U is disposed between the semiconductor chip 100g in the opening O1 of the pixel definition layer PDL and the circuit board S1. The underfill U may be used to fix the semiconductor chip 100g in the opening O1. A material of the underfill U may include acrylic, epoxy, siloxane, silicon dioxide, other suitable glue materials or a combination thereof, but the disclosure is not limited thereto.

The adhesive layer AD is disposed on the pixel definition layer PDL. The adhesive layer AD may cover the opening O1 and the semiconductor chip 100g.

The light enhancement unit 200 is disposed on the pixel definition layer PDL through an adhesive layer AD. The light enhancement unit 200 may be used to concentrate the light emitted by the semiconductor chip 100g to increase a brightness of the emitted light. The light enhancement unit 200 includes an insulating layer 210 and a reflective cup 220. The insulating layer 210 is disposed on the pixel definition layer PDL, and the insulating layer 210 has an opening 211 that may expose the semiconductor chip 100g. A material of the insulating layer 210 may be the same as or similar to the material of the pixel definition layer PDL, but the disclosure is not limited thereto.

The reflective cup 220 is disposed in the opening 211. The reflective cup 220 includes a high-transparent material layer 221 and a reflective material layer 222. The high-transparent material layer 221 has an upper surface 2211, a lower surface 2212, and a side surface 2213. The upper surface 2211 and the lower surface 2212 are opposite to each other, and the side surface 2213 connects the upper surface 2211 and the lower surface 2212. An included angle θ2 is formed between the upper surface 2211 and the side surface 2213. In the embodiment, the included angle θ2 may be between 10 degrees and 80 degrees, or between 30 degrees and 70 degrees, so as to improve light output efficiency or reduce (concentrate) a light output angle, but the disclosure is not limited thereto. A material of the high-transparent material layer 221 may be the same as or similar to the material of the filling layer 130, but the disclosure is not limited thereto. The reflective material layer 222 is disposed between the side surface 2213 of the high-transparent material layer 221 and the insulating layer 210. A material of the reflective material layer 222 may include silver, aluminum, or a distributed Bragg reflector (DBR), but the disclosure is not limited thereto.

The reflective cup 220 may overlap the semiconductor chip 100g in the direction Z (for example, a normal direction of the electronic device 10 or the normal direction of the semiconductor chip 100g). The high-transparent material layer 221 may overlap the first semiconductor element 110, the second semiconductor element 120a, and the third semiconductor element 180g in the semiconductor chip 100g in the direction Z.

In the direction X (for example, the extending direction of the section line E-E' in FIG. 12A), the lower surface 2212 of the high-transparent material layer 221 has a width W1, and the upper surface 131 of the filling layer 130 has a width W2. In the embodiment, the width W1 may be greater than the width W2, but the disclosure is not limited thereto.

The substrate S2 is disposed on the light enhancement unit 200. The adhesive layer AD may cover the insulating layer 210 and the reflective cup 220.

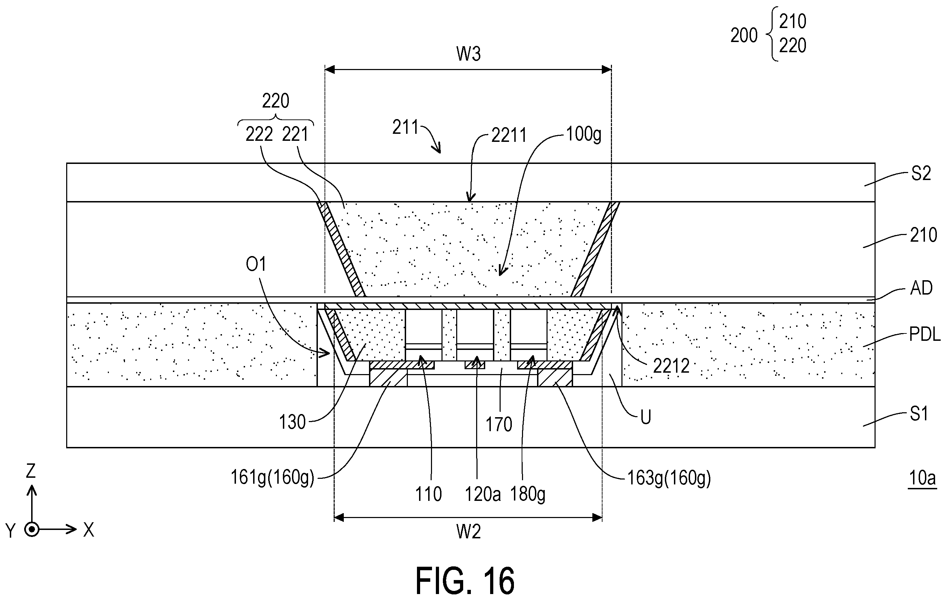

FIG. 16 is a schematic cross-sectional view of an electronic device according to another embodiment of the disclosure. Referring to FIG. 16 and FIG. 15 at the same time, an electronic device 10a of the embodiment is similar to the electronic device 10 of FIG15, and a difference there between is that in the electronic device 10 of the embodiment, a width W3 of the lower surface 2212 of the high-transparent material layer 221 is smaller than the width W2 of the upper surface 131 of the filling layer 130.

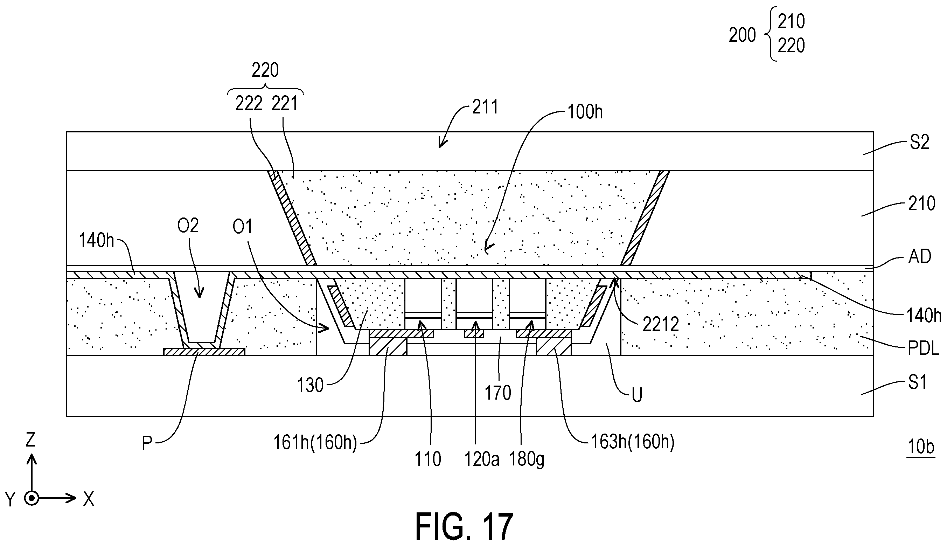

FIG. 17 is a schematic cross-sectional view of an electronic device according to another embodiment of the disclosure. Referring to FIG. 17 and FIG. 15 at the same time, an electronic device 10b of the embodiment is similar to the electronic device 10 of FIG. 15, and a difference there between is that in the electronic device 10b of the embodiment, the semiconductor chip 100g in FIG. 15 is replaced by the semiconductor chip 100h of FIG. 14A to FIG. 14C.

Specifically, referring to FIG. 17, the electronic device 10b further includes a conductive pad P. The conductive pad P is disposed on the circuit board S1, and the conductive pad P may be electrically connected to the circuit board S1. In the embodiment, the conductive pad P may be regarded as a second type electrode.

The pixel definition layer PDL further has an opening O2 for exposing the conductive pad P. The transparent conductive layer 140h of the semiconductor chip 100h extends to the opening O2 and is electrically connected to the conductive pad P. The insulating layer 210 of the light enhancement unit 200 may be filled in the opening O2.

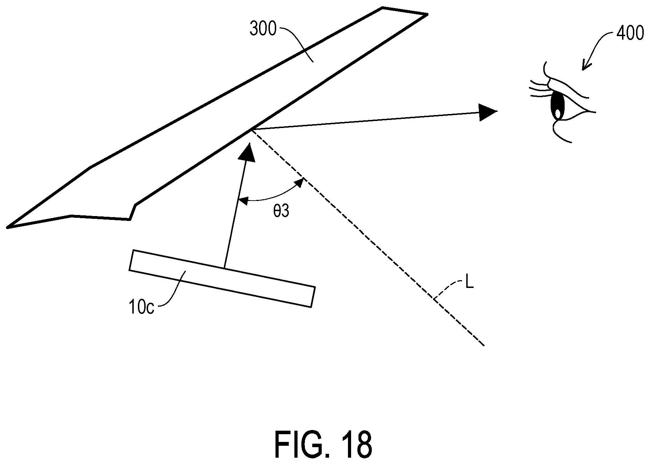

FIG. 18 is an application of an electronic device according to another embodiment of the disclosure. Referring to FIG. 18, an electronic device 10c of the disclosure may be a head-up display (HUD) or a panoramic head-up display (PHUD) for a vehicle, but the disclosure is not limited thereto.

The electronic device 10c disclosed herein may include the semiconductor chip 100 as shown in FIG. 2, the semiconductor chip 100b as shown in FIG. 6, the semiconductor chip 100c as shown in FIG. 7, the semiconductor chip 100d as shown in FIG. 8A to FIG. 8D, the semiconductor chip 100e as shown in FIG. 10A to FIG. 10B, the semiconductor chip 100f as shown in FIG. 11A to FIG. 11B, or the semiconductor chip 100g as shown in FIG. 12A to FIG. 12C, thereby providing highly concentrated light or high-brightness light, and accordingly reducing the influence of external ambient light.

In the embodiment, an image of the electronic device 10c may be projected onto a windshield 300 at an incident angle θ3 of 30 to 70 degrees relative to a normal line L of the glass 300, so that a driver 400 may see the image of the electronic device 10c through the windshield 300.

In summary, in the semiconductor chip of the disclosed embodiment, since the first semiconductor element and the second semiconductor element are arranged in series, power consumption may be reduced. By arranging the first type electrode and the second type electrode on the same side, detection of electric property may be performed after the semiconductor chip is transferred. In some embodiments, since the first semiconductor element and the second semiconductor element integrated in the same semiconductor chip implement configuration and circuit connection in the parallel manner, the defect rate or cost of repair may be reduced.

## Claims

1. A semiconductor chip (100, 100a, 100b, 100c, 100d, 100e, 100f, 100g, 100h), comprising:
a first semiconductor element (110);
a second semiconductor element (120, 120a), adjacent to the first semiconductor element (110);
a filling layer (130), wrapping the first semiconductor element (110) and the second semiconductor element (120, 120a);
a transparent conductive layer (140, 140b, 140d, 140g, 140h), disposed on the filling layer (130), and electrically connecting the first semiconductor element (110) and the second semiconductor element (120, 120a); and
a first metal layer (150, 150a, 150b, 150d, 150g, 150h), disposed under the filling layer (130), and comprising a first portion (151, 151a, 151b, 151d, 151g, 151h) and a second portion (152, 152a, 152b, 152d, 152g, 152h);
wherein the first portion (151, 151a, 151b, 151d, 151g, 151h) is electrically connected to at least one of the first semiconductor element (110) and the second semiconductor element (120, 120a), and the second portion (152, 152a, 152b, 152d, 152g, 152h) is disposed on a side surface (133) of the filling layer (130).

2. The semiconductor chip according to claim 1, wherein the transparent conductive layer (140b, 140g) is connected to the first metal layer (150b, 150g).

3. The semiconductor chip according to claim 2, wherein the first metal layer (150b, 150g) further comprises:
a third portion (153b, 153g), disposed under the filling layer (130),
wherein the first portion (151b, 151g) is electrically connected to a first type semiconductor layer (111) of the first semiconductor element (110) and a first type semiconductor layer (121) of the second semiconductor element (120a) through the second portion (152b, 152g) and the transparent conductive layer (140b, 140g), and the third portion (153b, 153g) is electrically connected to at least one of a second type semiconductor layer (113) of the first semiconductor element (110) and a second type semiconductor layer (123) of the second semiconductor element (120a).

4. The semiconductor chip according to claim 3, wherein the third portion (153b) is electrically connected to the second type semiconductor layer (113) of the first semiconductor element (110) and the second type semiconductor layer (123) of the second semiconductor element (120a).

5. The semiconductor chip according to claim 3, wherein the first metal layer (150g) further comprises:
a fourth portion (154g), disposed under the filling layer (130),
wherein the third portion (153g) is electrically connected to the second type semiconductor layer (113) of the first semiconductor element (110), and the fourth portion (154g) is electrically connected to the second type semiconductor layer (123) of the second semiconductor element (120a).

6. The semiconductor chip according to claim 5, wherein the first semiconductor element (110) and the second semiconductor element (120a) are respectively configured to emit light of different wavelengths.

7. The semiconductor chip according to claim 1, wherein the transparent conductive layer (140, 140d, 140h) and the first metal layer (150, 150a, 150d, 150h) are separated from each other.

8. The semiconductor chip according to claim 7, wherein the first semiconductor element (110) and the second semiconductor element (120, 120a) are respectively configured to emit light of a same wavelength.

9. The semiconductor chip according to claim 7, wherein the first metal layer (150, 150d) also comprises:
a third portion (153, 153d), disposed under the filling layer (130),
wherein the transparent conductive layer (140, 140d) is electrically connected to a first type semiconductor layer (111) of the first semiconductor element (110) and a second type semiconductor layer (123) of the second semiconductor element (120), the first portion (151, 151d) is electrically connected to a second type semiconductor layer (113) of the first semiconductor element (110), and the third portion (153, 153d) is electrically connected to a first type semiconductor layer (121) of the second semiconductor element (120).

10. The semiconductor chip according to claim 9, wherein the first portion (151, 151d) and the third portion (153, 153d) are separated from each other.

11. The semiconductor chip according to claim 7, wherein the transparent conductive layer (140, 140h) is electrically connected to a first type semiconductor layer (111) of the first semiconductor element (110) and a first type semiconductor layer (121) of the second semiconductor element (120a), and the first portion (151a, 151h) is electrically connected to at least one of a second type semiconductor layer (113) of the first semiconductor element (110) and a second type semiconductor layer (123) of the second semiconductor element (120a).

12. The semiconductor chip according to claim 11, wherein the first portion (151a) is electrically connected to the second type semiconductor layer (113) of the first semiconductor element (110) and the second type semiconductor layer (123) of the second semiconductor element (120a).

13. The semiconductor chip according to claim 11, wherein the first metal layer (150h) further comprises:
a third portion (153h), disposed under the filling layer (130),
wherein the first portion (151h) is electrically connected to the second type semiconductor layer (113) of the first semiconductor element (110), and the third portion (153h) is electrically connected to the second type semiconductor layer (123) of the second semiconductor element (120a).

14. The semiconductor chip according to claim 13, wherein the first semiconductor element (110) and the second semiconductor element (120a) are respectively configured to emit light of different wavelengths.

15. The semiconductor chip according to claim 13, wherein the first metal layer (150h) further comprises:
a redundant portion (156h), disposed under the filling layer (130), wherein the redundant portion (156h) is electrically insulated from the first semiconductor element (110), and the redundant portion (156h) is electrically insulated from the second semiconductor element (120a).
